# EUROPEAN PATENT APPLICATION

(11) **EP 2 071 788 A1**
(43) Date of publication of application: **17.06.2009**
(21) Application number: 07291513.5
(22) Date of filing: 13.12.2007
(51) Int. Cl.: H04L 27/26, H03F 3/21, H03F 3/60

(54) **Method of providing a multi-carrier signal and transmitter**

(71) Applicant: Alcatel Lucent, 75008 Paris (FR)
(72) Inventor: Nass, Toblas, 70435 Stuttgart (DE); Bitzer, Thomas, 73614 Schorndorf (DE); Pascht, Andreas, 73614 Schorndorf (DE)
(74) Representative: Schäfer, Wolfgang

(57) **Abstract**

The invention relates to a method of providing a multi-carrier signal (mc) comprising a plurality of single-carrier signals (sc_1, .., sc_m), wherein m many single-carrier signals (sc_1, .., sc_m) are combined to obtain said multi-carrier signal (mc).

According to the present invention, said method is characterized by:
- providing n many instances (mc1_1, .., mc1_n) of a first stage multi-carrier signal by combining said m many single-carrier signals (sc_1, .., sc_m) within a first combining stage, wherein said n many instances (mc1_1, .., mc1_n) of said first stage multi-carrier signals have a predetermined amplitude and phase relationship to each other,
- combining said n many instances (mc1_1, .., mc1_n) of said first stage multi-carrier signal to obtain said multi-carrier signal (mc).

## Description

The present invention relates to a method of providing a multi-carrier signal comprising a plurality of single-carrier signals, wherein m many single-carrier signals are combined to obtain said multi-carrier signal.

The present invention further relates to a transmitter for transmitting a multi-carrier signal.

Methods and transmitters of the aforementioned type are per se known. Currently, three different ways of generating multi-carrier signals are widely used.

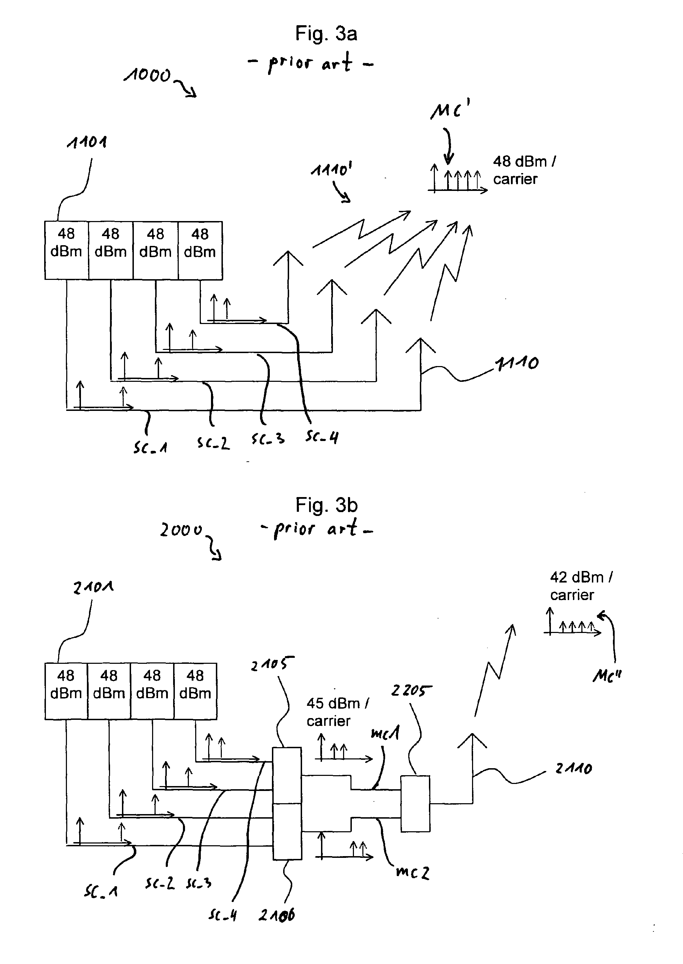

A first conventional solution which is also known as "air combining" proposes to use several single-carrier transmitters each of which is provided with an own dedicated antenna. Figure 3a depicts a corresponding scenario of a prior art transmitter 1000, in which four single-carrier transmitters 1101 provide respective single-carrier signals sc_1, sc_2, sc_3, sc_4 at an output power level of 48 dBm each. The respective spectra are also shown in Figure 3a for illustration purposes. Each of said single-carrier signals sc_1, sc_2, sc_3, sc_4 is transmitted via a respective antenna 1110, which is symbolized by the arrow 1110', and received at a receiver which is not depicted by Figure 3a. The spectrum MC' as received at such receiver is illustrated in Figure 3a.

Although the resulting spectrum MC' of the multi-carrier signal comprises the distinct single-carrier signals sc_1, sc_2, sc_3, sc_4 with a comparatively high output power of 48 dBm each, the air combining solution is particularly disadvantageous, since for each individual single-carrier signal sc_1, sc_2, sc_3, sc_4 which is to be combined, a dedicated transmitter 1101 and a corresponding antenna 1110 has to be provided. The actual combination of the single-carrier signals sc_1, sc_2, sc_3, sc_4 is only performed after these single-carrier signals sc_1, sc_2, sc_3, sc_4 have been emitted by the individual antenna 1110, i.e. in the air or at a receiving antenna, respectively, which receives more than one of the radiated single-carrier signals.

A second conventional approach to providing a multi-carrier signal is based on using several single-carrier transmitters 2101 as mentioned above with respect to the technique of air combining. Instead of feeding each single-carrier signal sc_1, sc_2, sc_3, sc_4 to a separate antenna 1110, however, multiple single-carrier signals sc_1, sc_2, sc_3, sc_4 are combined and fed to one common antenna 2110, as depicted by Figure 3b. This approach, which is also denoted as hybrid combining, has the advantage of only requiring a single antenna 2110. A major drawback of the hybrid combining technique, however, is the comparatively low output power as compared to the air combining, because the process of combining the multiple single-carrier signals sc_1, sc_2, sc_3, sc_4 by means of conventional combiners 2105, 2106 in most cases leads to a decrease of output power per carrier of up to 3 dB, i.e. only half of the input power is transmitted to an output port of the respective combiners.

Within the present example of prior art transmitter 2000, the single-carrier signals sc_1, sc_2 are combined to a first multi-carrier signal mc2, and the single-carrier signals sc_3, sc_4 are combined to a second multi-carrier signal mc1. Since each of the conventional combiners 2105, 2106 causes a loss of 3 dB, the multi-carrier signals mc1, mc2 conventionally obtained only comprise a power level of 45 dBm per carrier. When subsequently combining the so obtained multi-carrier signals mc1, mc2 to the desired multi-carrier signal by means of the further combiner 2205, again a loss of 3 dB per carrier is induced. Consequently, the conventionally obtained desired multi-carrier signal only comprises a power level of 42 dBm per carrier as depicted in combination with the corresponding spectrum MC''.

A third solution for providing a multi-carrier signal well known in the art proposes to use an individual multi-carrier transmitter to overcome the high number of single carrier transmitters required by the above described prior art systems. This solution, however, has several disadvantages as far as the possible output power level per carrier is concerned, because the output power of a single power amplifier comprised within said multi-carrier transmitter is limited and must be shared among the different single-carrier signals constituting the processed multi-carrier signal. Additionally, due to signal statistic reasons, an additional output power back-off might be necessary to avoid saturation of the power amplifier.

Consequently, it is an object of the present invention to improve a method of providing a multi-carrier signal and a corresponding transmitter of the above mentioned type such that less antenna hardware is required as compared to the air combining approach while at the same time avoiding the substantial output power losses of the hybrid combining approach or the limitation of a single multi-carrier transmitter device.

According to the present invention, regarding the above mentioned method, this object is achieved by:
providing n many instances of a first stage multi-carrier signal by combining said m many single-carrier signals within a single-carrier combining stage, wherein said n many instances of said first stage multi-carrier signals have a predetermined amplitude and phase relationship to each other, and by
combining said n many instances of said first stage multi-carrier signal to obtain said multi-carrier signal.

In contrast to the above discussed prior art solutions, the inventive method advantageously provides for combining a plurality of different instances of a first stage multi-carrier signal. Said different instances of said first stage multi-carrier signal advantageously have a predetermined amplitude and phase relationship to each other, which ensures that the combining losses known from conventional systems do not occur or are at least reduced.

According to a very advantageous embodiment of the present invention, said n many instances of said first stage multi-carrier signals have equal amplitudes and phase. That is, according to the present invention, the m many single-carrier signals are combined such as to form n many substantially identical first stage multi-carrier signals which have particularly advantageous properties for subsequently combing them into the desired multi-carrier signal. Even when using conventional combiners, substantially identical instances of first stage multi-carrier signals do not suffer from the above described 3 dB losses because in the inventive configuration, the combiners can operate in an even mode regarding their input signals. In contrast thereto, the signals combined according to one of the conventional approaches are usually completely uncorrelated to each other thus not enabling a combiner to be operated in even mode, whereby the mentioned losses of up to 3 dB are induced.

Consequently, the inventive combination of first providing n many instances of substantially identical first stage multi-carrier signals with a following process of combining advantageously enables to combine the first stage multi-carrier signals in an even mode thus avoiding the signal losses experienced with prior art systems.

Therefore, the method according to the present invention does not require a plurality of separate dedicated antennas as the prior art air combining approach which largely avoids signal combining except related to the radiated signals. Furthermore, as already explained above, the combining losses experienced with a hybrid combining approach of prior art are also avoided.

A further significant advantage of the inventive method is based on the fact that by using the inventive method an output power level of the desired multi-carrier signal can arbitrarily be scaled, which is accomplished by appropriately choosing the number n of instances of said first stage multi-carrier signal and/or the number of multi-carrier combining stages depending on the desired amplification or output power level of the multi-carrier signal, respectively.

According to a further advantageous variant of the present invention, said step of combining said n many instances of said first stage multi-carrier signal comprises the following steps:
- combining said n many instances of said first stage multi-carrier signal within a first multi-carrier combining stage to obtain n2<n many instances of a second stage multi-carrier signal,
- combining said n2 many instances of said second stage multi-carrier signal within a second multi-carrier combining stage to obtain said multi-carrier signal.

Although the abovementioned configuration of the present invention is particularly preferred, especially for values of n=4 and m=4, it is generally possible to provide any other number of instances of the first stage multi-carrier signal and any other number of single-carrier signals to be combined into the desired multi-carrier signal.

Furthermore, it is also possible to employ further, i.e. more than two, combining stages for subsequently combining n-th stage multi-carrier signals in order to obtain (n+1)-th stage multi-carrier signals and so forth.

As already explained above, since according to the present invention there are substantially no combining losses, a desired output power level for the multi-carrier signal may easily be achieved by appropriately providing a respective number of combining stages and a corresponding number of single-carrier signals as input signals as well as a corresponding number n of instances of the first stage multi-carrier signal.

According to a further advantageous embodiment of the inventive method, the steps of combining may be performed by conventional signal combiners which isolatedly add two or more single-carrier input signals to obtain a corresponding multi-carrier output signal without transmitting a specific multi-carrier input signal to further inputs of the combiner. Preferably, a Wilkinson combiner may be used.

Any other combining means which also enable an even mode operation when being supplied with the inventive substantially identical n many instances of a first stage multi-carrier signal can also be used for performing the method according to the present invention.

According to another very advantageous embodiment of the present invention, said n many instances of said first stage multi-carrier signal are obtained by multi-carrier transmitter means. Said multi-carrier transmitter means may e.g. receive a first number of base band signals which are separately or jointly modulated in a per se known manner by using respective carrier signals so as to obtain a multi-carrier signal which comprises the respective input signals in various passband frequency ranges centered around the frequency of the respective carrier signal.

A further solution to the object of the present invention is given in form of a transmitter according to claim 8.

The inventive transmitter comprises a single-carrier combining stage which provides n many instances of a first stage multi-carrier signal by combining said m many single-carrier signals, wherein said n many instances of said first stage multi-carrier signals have a predetermined amplitude and phase relationship to each other. Furthermore, the inventive transmitter comprises one or more multi-carrier combining stages for combining said n many instances of said first stage multi-carrier signal to obtain said multi-carrier signal.

A particularly advantageous embodiment of the inventive transmitter is characterized in that the number m of single-carrier signals to be combined is a power of two and in that ld(m) (ld(m): logarithmus dualis of m) many multi-carrier combining stages are provided. For instance, a preferred embodiment of the inventive transmitter may comprise m=4 single-carrier signals and ld(4)=2 multi-carrier combining stages, wherein each combiner of the multi-carrier combining stages combines two multi-carrier signals in the inventive manner.

Although the method and transmitter according to the present invention are preferably used within base stations of mobile communication systems, any other field of application which requires the generation of multi-carrier signals out of single-carrier signals in an efficient manner can also make use of the inventive principle. Particularly, any type of modulation scheme or communication standard utilizing multi-carrier signals can advantageously make use of the present invention.

Advantageous embodiments and variants of the present invention are given by the dependent claims.

Further advantageous embodiments and details of the present invention are given in the following detailed description with reference to the drawings in which:
- Figure 1: depicts an inventive single-carrier combining stage for obtaining a first stage multi-carrier signal,
- Figure 2: depicts a two-stage transmitter architecture for obtaining a multi-carrier signal according to a method of the present invention, and
- Figure 3a and Figure 3b: depict different variants of conventional systems for generating multi-carrier signals.

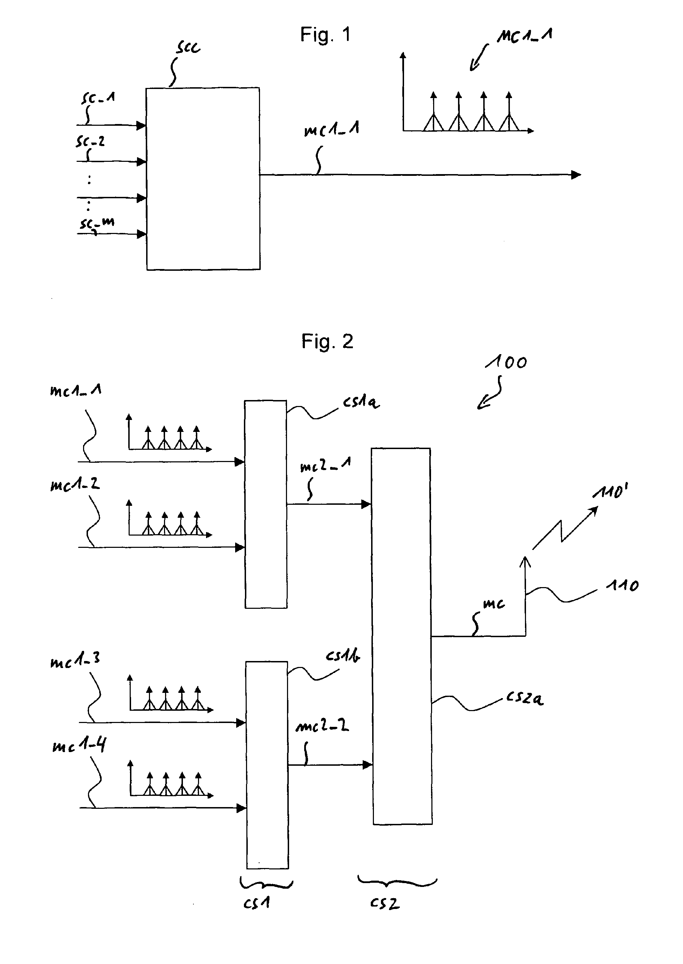

Figure 1 schematically depicts a single-carrier combining means scc which receives at its inputs m many single-carrier signals sc₌1, sc_2, .., sc_m and which combines these single-carrier signals sc_1, sc_2, .., sc_m into a first instance mc1_1 of a first stage multi-carrier signal.

A spectrum MC1_1 of the so obtained instance mc1_1 of the first stage multi-carrier signal is also depicted within Figure 1.

According to the method of the present invention, an overall number of n many instances mc1_1, .., mc1_n is generated by further single-carrier combining stages that are comparable to the depicted single-carrier combining stage scc.

For the present example, m=4 single-carrier signals sc_1, .., sc_4 are considered, and the number n of instances of the first stage multi-carrier signal is selected to be n=4.

Figure 2 depicts a corresponding architecture of an inventive transmitter 100 which has two subsequent multi-carrier combining stages cs1, cs2.

The first multi-carrier combining stage cs1 comprises two combiners cs1a, cs1b which may preferably be configured as Wilkinson combiners.

As depicted by Figure 2, two instances mc1_1, mc1_2 of the first stage multi-carrier signal already described with reference to Figure 1 are supplied to the first Wilkinson combiner cs1a.

According to the present invention, each of said n=4 instances mc1_1, .., mc1_4 of the first stage multi-carrier signal has a predetermined amplitude and phase relationship with respect to the other instances, particularly equal amplitudes and phase, which advantageously enables the first Wilkinson combiner cs1a to operate in an even mode when combining the two instances mc1_1, mc1_2 of the first stage multi-carrier signal thus not causing substantial losses of an output power of the second stage multi-carrier signal mc2_1.

That is, in contrast to prior art systems as depicted by Figure 3a, 3b, since the Wilkinson combiner cs1a operates in an even mode, there are substantially no losses of the signals mc1_1, mc1_2 combined according to the present invention.

The further instances mc1_3, mc1_4 also comprise equal amplitudes and phase and are thus also combined by the further Wilkinson combiner cs1b of the first multi-carrier combining stage cs1 to the second stage multi-carrier signal mc2_2 without any losses.

The so obtained second-stage multi-carrier signals mc2_1, mc2_2 are in turn combined by the combiner cs2a of the second multi-carrier combining stage cs2 of the inventive transmitter architecture according to Figure 2.

As already described with respect to the combining processes within the first multi-carrier combining stage cs1, the process of combining the second stage multi-carrier signals mc2_1, mc2_2 is also based on an even mode operation of the Wilkinson combiner cs2a of the second multi-carrier combining stage cs2 and thus also advantageously avoids any substantial losses regarding an output power level of the desired multi-carrier signal mc that is obtained at an output of the Wilkinson combiner cs2a.

The multi-carrier signal mc obtained according to the method of the present invention is subsequently fed to a single antenna 110 and transmitted to a receiver not depicted by Figure 2 as symbolized by the flash arrow 110'.

The basic principle of the present invention is based on the fact that any combiner cs1a, cs1b, cs2a is operated in an even mode when combining multi-carrier signals which advantageously enables to repeatedly combine corresponding multi-carrier signals mc1_1, .., mc2_2 without suffering substantial losses regarding an output power level of the multi-carrier signal mc.

The even mode operation of the combiners cs1a, cs1b, cs2a according to the present invention is best achieved by providing the respective input signals with the same amplitude and a predefined phase difference, particularly of 0°. Slight amplitude and phase differences, however, may be tolerated since they do not inevitably lead to the losses that are experienced with the prior art systems of Figure 3b, which are due to the complete decorrelation of the input signals used by the prior art methods. In contrast to the prior art systems, the present invention uses well-correlated signals, i.e. the instances mc1_1, .. and the multi-carrier signals mc2_1, .. obtained therefrom, which enable a lossless even mode combining operation within the combining stages cs1, cs2.

Optionally, different processing delays or gain factors within separate combiners cs1a, cs2a may be compensated for by appropriate compensation means well known in the art to ensure a mode of operation of a subsequent combiner cs2a which is as close to the ideal even mode operation as possible. Such compensation means, which are presently not depicted in Figure 2, may e.g. be provided between the respective combining stages cs1, cs2.

At the same time, only one single antenna 110 is required by the inventive transmitter structure 100, because in contrast to the conventional technique of air combining, the inventive method provides for the combination of signals by means of the combining stages cs1, cs2.

A particularly preferred embodiment of the present invention is characterized by using a number m of single-carrier signals sc_1, .., sc_m which is a power of two, i.e. m = 2^x, and by using ld(m)=x many multi-carrier combining stages cs1, ...

Although the method and transmitter 100 according to the present invention are preferably used within base stations of mobile communication systems such as GSM and UMTS, any other field of application which requires the generation of multi-carrier signals mc out of single-carrier signals sc_1, .. in an efficient manner can also make use of the inventive principle. Particularly, any type of modulation scheme or communication standard utilizing multi-carrier signals mc can advantageously make use of the present invention.

A further significant advantage of the inventive method is based on the fact that by using the inventive method an output power level of the desired multi-carrier signal mc can arbitrarily be scaled, which is accomplished by appropriately choosing the number n of instances of said first stage multi-carrier signal and/or the number of multi-carrier combining stages cs1, .. depending on the desired amplification or output power level of the multi-carrier signal mc, respectively. As long as the amplitude and phase relationships as demanded by the inventive principle are maintained, any number of stages may be employed, which is particularly advantageous in view of conventional multi-carrier transmitters that only have a very limited output power.

As an example, the instances mc1_1, .. of Figure 2 may be provided with a power level of 48 dBm, i.e. 42 dBm per carrier, and the successive inventive combination of the signals mc1_1, .., mc2_2 in the combining stages cs1, cs2 yields a multi carrier signal mc having a power level of 48 dBm per carrier.

## Claims

1. Method of providing a multi-carrier signal (mc) comprising a plurality of single-carrier signals (sc_1, .., sc_m), wherein m many single-carrier signals (sc_1, .., sc_m) are combined to obtain said multi-carrier signal (mc), said method being **characterized by**:
- providing n many instances (mc1_1, .., mc1_n) of a first stage multi-carrier signal by combining said m many single-carrier signals (sc_1, .., sc_m) within a single-carrier combining stage, wherein said n many instances (mc1_1, .., mc1_n) of said first stage multi-carrier signals have a predetermined amplitude and phase relationship to each other,
- combining said n many instances (mc1_1, .., mc1_n) of said first stage multi-carrier signal to obtain said multi-carrier signal (mc).

2. Method according to claim 1, **characterized in that** said n many instances (mc1_1, .., mc1_n) of said first stage multi-carrier signal have equal amplitudes and phase.

3. Method according to claim 1 or 2, **characterized in that** said step of combining said n many instances (mc1_1, .., mc1_n) of said first stage multi-carrier signal comprises the following steps:
- combining said n many instances (mc1_1, .., mc1_n) of said first stage multi-carrier signal within a first multi-carrier combining stage (cs1) to obtain n2 < n many instances (mc2_1, .., mc2_n2) of a second stage multi-carrier signal,
- combining said n2 many instances (mc2_1, .., mc2_n2) of said second stage multi-carrier signal within a second multi-carrier combining stage (cs2) to obtain said multi-carrier signal (mc).

4. Method according to claim 3, **characterized by** employing further combining stages for subsequently combining n-th stage multi-carrier signals to obtain (n+1)-th stage multi-carrier signals.

5. Method according to one of the preceding claims, **characterized in that** said number n of instances (mc1_1, .., mc1_n) of a first stage multi-carrier signal and/or the number of multi-carrier combining stages (cs1, cs2) is chosen depending on a desired amplification for said multi-carrier signal (mc).

6. Method according to one of the preceding claims, **characterized in that** said n-th stage multi-carrier signals are combined by means of a signal combiner, particularly a Wilkinson combiner.

7. Method according to one of the preceding claims, **characterized in that** said n many instances (mc1_1, .., mc1_n) of said first stage multi-carrier signal are obtained by multi-carrier transmitter means.

8. Transmitter (100) for transmitting a multi-carrier signal (mc) comprising a plurality of single-carrier signals (sc_1, .., sc_m), wherein one or more combiners are provided for combining m many single-carrier signals (sc_1, .., sc_m) to obtain said multi-carrier signal (mc), **characterized by** a single-carrier combining stage which provides n many instances (mc1_1, .., mc1_n) of a first stage multi-carrier signal by combining said m many single-carrier signals (sc_1, .., sc_m), wherein said n many instances (mc1_1, .., mc1_n) of said first stage multi-carrier signals have a predetermined amplitude and phase relationship to each other, and by one or more multi-carrier combining stages (cs1, cs2) for combining said n many instances (mc1_1, .., mc1_n) of said first stage multi-carrier signal to obtain said multi-carrier signal (mc).

9. Transmitter (100) according to claim 8, **characterized in that** said combining stages comprise one or more Wilkinson combiners.

10. Transmitter (100) according to claim 8 or 9,
**characterized in that** the number m of single-carrier signals (sc_1, .., sc_m) to be combined is a power of two, and **in that** ld(m) many multi-carrier combining stages (cs1, cs2) are provided.

11. Base station for a mobile communications network
comprising one or more transmitters (100) according to one of the claims 8 to 10.
